# EUROPEAN PATENT APPLICATION

(11) **EP 4 691 668 A1**
(43) Date of publication of application: **11.02.2026**
(21) Application number: 25178787.5
(22) Date of filing: 26.05.2025
(51) Int. Cl.: B22F 1/10, B22F 7/06, B23K 35/02, H01L 23/00, B22F 7/04

(54) **SINTER BONDING SHEET, AND METHOD FOR PRODUCING SINTER BONDING SHEET**

(30) Priority: 25.06.2024 JP 2024102214
(71) Applicant: NITTO DENKO CORPORATION, Ibaraki-shi Osaka 567-8680 (JP)
(72) Inventor: Okoba, Yuichi, Ibaraki-shi, Osaka, 567-8680 (JP); Mita, Ryota, Ibaraki-shi, Osaka, 567-8680 (JP)
(74) Representative: Grünecker Patent- und Rechtsanwälte PartG mbB

(57) **Abstract**

Provided is, for example, a sinter bonding sheet including: a sinter bonding layer including sinterable particles containing a conductive metal, and an organic binder; and a substrate layer layered on at least one surface of the sinter bonding layer, in which the at least one surface of the sinter bonding layer on which the substrate layer is layered has a surface roughness Ra of 10.5 nm or more and 90.0 nm or less.

## Description

### FIELD OF THE INVENTION

The present invention relates to a sinter bonding sheet used for producing, for example, a semiconductor device. The present invention also relates to a method for producing, for example, the sinter bonding sheet.

### BACKGROUND OF THE INVENTION

Conventionally known is a sinter bonding sheet used for producing a semiconductor device. The sinter bonding sheet of this type includes a sinter bonding layer including: sinterable particles containing a conductive metal; and an organic binder. The sinter bonding layer including the organic binder has pressure-sensitive adhesiveness. In producing the semiconductor device, the sinter bonding layer is placed between one surface of a board and a semiconductor element (e.g., semiconductor chip) and subjected to sintering treatment to thereby allow the board and the semiconductor element to be bonded to each other via the sinter bonding layer. For example, steps as shown below are carried out to produce the semiconductor device.
(1) A dicing tape formed of a support layer and an adhesive layer laminated on each other is prepared, and a semiconductor wafer is attached on the adhesive layer of the dicing tape for fixing, followed by being divided by dicing into a plurality of individual semiconductor elements.
(2) One of the plurality of semiconductor elements is separated from the adhesive layer and lifted up using a jig such as a collet, and the one semiconductor element is then pressed on a sinter bonding layer of a sinter bonding sheet. With such pressing force, a portion of the sinter bonding layer is cut out into an individual piece having such a size as to correspond to the size of the one semiconductor element. The individual piece of the sinter bonding layer is simultaneously caused to adhere to the semiconductor element, and the jig such as the collet is pulled up to thereby pick up the one semiconductor element with the individual piece of the sinter bonding layer adhering thereto. Hereinafter, the case where such pickup can be well performed is referred to also as the case having "good transfer properties to the semiconductor chip".
(3) The one semiconductor element with the individual piece of the sinter bonding layer adhering thereto is caused to adhere to one surface of a board (i.e., a mounting area of a semiconductor element). That is, the one semiconductor element is temporarily fixed to the board.
(4) Steps (2) and (3) are similarly carried out a plurality of times to temporarily fix a plurality of the semiconductor elements with the individual pieces of the sinter bonding layer respectively adhering thereto within the mounting areas of the semiconductor elements. An intermediate product of the semiconductor device is thus obtained.
(5) The intermediate product of the semiconductor device is subjected to sintering treatment in which the intermediate product of the semiconductor device is heated at a temperature at which sinterable particles in the sinter bonding layer can be sintered to each other, to thereby at least partially eliminate the organic binder from the sinter bonding layer while sintering the sinterable particles to each other. Thus, the plurality of semiconductor elements are bonded to the respective mounting areas of the semiconductor elements.

After the above steps are carried out, the sinterable particles included in the sinter bonding layer are sintered to each other to thereby allow the plurality of semiconductor elements to be fixed within the respective mounting areas of the semiconductor elements in the board. That is, the plurality of semiconductor elements are fixed to the respective mounting areas of the semiconductor elements in the board via the respective individual pieces of the sinter bonding layer that have been subjected to sintering treatment.

In substitution for steps (1) and (2) above, it is also possible in producing the semiconductor device that: the sinter bonding layer be layered on the adhesive layer of the dicing tape and the semiconductor wafer be further attached to the sinter bonding layer; and the semiconductor wafer with the sinter bonding layer attached thereto be divided into individual pieces to pick up a semiconductor element with the sinter bonding layer attached thereto.

Known as a sinter bonding sheet that can be used in carrying out the method for producing the semiconductor device as above is, for example, a roll body including a sinter bonding layer that turns a firm sintered layer after sintering treatment, and a substrate layer (for example, JP 2020-147706 A).

Specifically, the roll body disclosed in JP 2020-147706 A is a layered product of the sinter bonding layer and the substrate layer formed in a rolled state, and the layered product has a thickness of 10 to 300 µm. A surface of the sinter bonding layer facing the substrate layer has a surface roughness of, for example, 50 µm or less.

### SUMMARY OF THE INVENTION

### Technical Problem

When the pickup as described above is performed simply using the layered product (layered product of the sinter bonding layer and the substrate layer) described in JP 2020-147706 A, there are some cases where no good separation occurs between the sinter bonding layer and the substrate layer, resulting in wrinkles on the sinter bonding layer and failing to necessarily achieve good transfer properties. On the other hand, there are cases where the substrate layer is separated and lifted from the sinter bonding layer when, for example, the above layered product is rolled up, due to the tight adhesiveness being not necessarily favorable between the sinter bonding layer and the substrate layer.

Thus, good transfer properties are not necessarily achieved when the above pickup is performed simply using the layered product of the sinter bonding layer and the substrate layer described in JP 2020-147706 A.

Further, the layered product of the sinter bonding layer and the substrate layer described in JP 2020-147706 A is not necessarily configured to suppress the substrate layer from being separated and lifted from the sinter bonding layer.

However, no sufficient consideration appears to have been made on a sinter bonding sheet having good transfer properties of the sinter bonding layer to the semiconductor chip and configured to allow the substrate layer to be less likely separated and lifted from the sinter bonding layer.

It is therefore an object of the present invention to provide a sinter bonding sheet having good transfer properties of the sinter bonding layer to the semiconductor chip and configured to allow the substrate layer to be less likely separated and lifted from the sinter bonding layer.

### Solution to Problem

In order to solve the above problem, a sinter bonding sheet according to the present invention includes:
a sinter bonding layer including sinterable particles containing a conductive metal, and an organic binder; and
a substrate layer layered on at least one surface of the sinter bonding layer, in which
the at least one surface of the sinter bonding layer on which the substrate layer is layered has a surface roughness Ra of 10.5 nm or more and 90.0 nm or less.

A method for producing a sinter bonding sheet according to the present invention is a method for producing a sinter bonding sheet including: a sinter bonding layer including sinterable particles containing a conductive metal, and an organic binder; and a substrate layer layered on at least one surface of the sinter bonding layer, the method including:
forming a plurality of intermediates of the sinter bonding layer each into a sheet shape by volatilizing a solvent from a varnish including the sinterable particles, the organic binder, and the solvent; and
applying press treatment to the sinter bonding layer formed by attaching the plurality of intermediates to each other, in which
in the press treatment, a pressure of 0.1 MPa or more and 10.0 MPa or less is applied at a temperature of 30 °C or more and 150 °C or less to the sinter bonding layer with the at least one surface thereof being in abutting contact with the substrate layer.

### BRIEF DESCRIPTION OF DRAWINGS

Fig. 1A is a schematic cross-sectional view of a sinter bonding sheet of this embodiment obtained by cutting the sinter bonding sheet in its thickness direction.
Fig. 1B is a schematic cross-sectional view of a portion of the sinter bonding sheet of this embodiment obtained by unwinding the portion from the sinter bonding sheet in a rolled state and cutting the portion in its thickness direction.
Fig. 2A is a schematic cross-sectional view showing part of a specific example of producing equipment for carrying out a method for producing the sinter bonding sheet of this embodiment.
Fig. 2B is a schematic cross-sectional view showing part of a specific example of producing equipment for carrying out the method for producing the sinter bonding sheet of this embodiment.
Fig. 2C is a schematic cross-sectional view showing part of a specific example of producing equipment for implementing the method for producing the sinter bonding sheet of this embodiment.
Fig. 3A is a schematic cross-sectional view showing a state where one semiconductor chip is lifted up from a dicing tape by a collet.
Fig. 3B is a schematic cross-sectional view showing a state where a part of a sinter bonding layer of the sinter bonding sheet is cut out into an individual piece.
Fig. 3C is a schematic cross-sectional view showing a state where a part of the sinter bonding layer of the sinter bonding sheet is cut out into an individual piece.
Fig. 3D is a schematic cross-sectional view showing a state where the one semiconductor chip with the individual piece of the sinter bonding layer adhering thereto is temporarily fixed to a board.
Fig. 4A is a schematic cross-sectional view showing a state where another semiconductor chip is lifted up from the dicing tape by the collet.
Fig. 4B is a schematic cross-sectional view showing a state where the other semiconductor chip with the individual piece of the sinter bonding layer adhering thereto is temporarily fixed to a board.
Fig. 5A is a schematic cross-sectional view showing an example state where the individual piece of the sinter bonding layer is heated while being pressed.
Fig. 5B is a schematic cross-sectional view showing another example state where the individual piece of the sinter bonding layer is heated without being pressed.

### DETAILED DESCRIPTION OF THE PREFERRED EMBODIMENT

A description will be hereinafter given on one embodiment of a sinter bonding sheet according to the present invention with reference to the drawings.

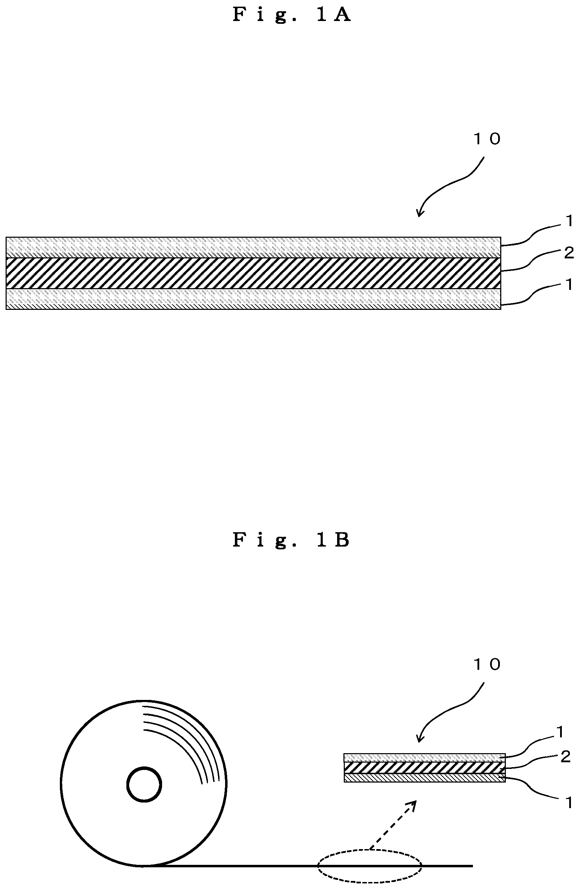

As shown in Fig. 1A and Fig. 1B, a sinter bonding sheet 10 according to this embodiment includes a sinter bonding layer 2 that includes: sinterable particles containing a conductive metal; and an organic binder. A substrate layer 1 is layered on at least one surface (one surface or both surfaces) of the sinter bonding layer 2. The sinter bonding sheet 10 of this embodiment has, for example, an elongated strip shape. The sinter bonding sheet 10 of this embodiment can be stored in a state rolled into a cylindrical shape.

### [Sinter bonding layer of sinter bonding sheet]

The sinter bonding layer 2 including the organic binder has pressure-sensitive adhesiveness. Thus, the sinter bonding layer 2 subjected to pressing force can temporarily adhere to an adherend. When the sinter bonding layer 2 is subjected to sintering treatment, sinterable particles therein are sintered to each other. The sinter bonding layer 2 after sintering treatment is disposed, for example, between a board and a semiconductor chip B for bonding these to each other. The sinter bonding layer 2 after sintering treatment has the organic binder at least partially eliminated. The organic binder in the sinter bonding layer 2 after sintering treatment is preferably substantially absent, more preferably totally absent.

At least one surface of the sinter bonding layer 2 (i.e., the surface of the sinter bonding layer 2 facing the substrate layer 1) has a surface roughness Ra of 10.5 nm or more and 90.0 nm or less. As will be described in detail later, the sinter bonding layer 2 configured as above has good transfer properties to a semiconductor chip. Also, the sinter bonding sheet 10 including the sinter bonding layer 2 configured as above can suppress the substrate layer 1 from being separated and lifted from the sinter bonding layer 2. In the case of the surface roughness Ra falling below 10.5 nm, no good separation occurs between an individual piece of the sinter bonding layer 2 and the substrate layer 1 when a semiconductor element is pressed at the sinter bonding layer 2 layered on the substrate layer and thereafter a semiconductor chip with the individual piece of the sinter bonding layer 2 adhering thereto is lifted up (picked up). This may result in wrinkles on the sinter bonding layer 2. Accordingly, no good transfer properties to the semiconductor chip can be exhibited. In contrast, the surface roughness Ra exceeding 90.0 nm results in poor tight adhesiveness between the substrate layer 1 and the sinter bonding layer 2, failing to favorably cut out the sinter bonding layer 2 into an individual piece by pressing one semiconductor element at the sinter bonding layer 2. This may result in poor transfer properties to the semiconductor chip. The poor tight adhesiveness between the substrate layer 1 and the sinter bonding layer 2 tends to cause separation between the substrate layer 1 and the sinter bonding layer 2 when, for example, a layered product of the substrate layer 1 and the sinter bonding layer 2 is bent. That is, the substrate layer 1 tends to be lifted from the sinter bonding layer 2. When two substrate layers 1 are respectively layered on both surfaces of the sinter bonding layer 2, as shown in Fig. 1A and Fig. 1B, one of the both surfaces can have a surface roughness Ra of 10.5 nm or more and 90.0 nm or less, or the both surfaces can each have a surface roughness Ra of 10.5 nm or more and 90.0 nm or less. When one substrate layer 1 is layered on one of the surfaces of the sinter bonding layer 2, the surface on which the substrate layer 1 is layered has a surface roughness Ra of 10.5 nm or more and 90.0 nm or less.

The surface roughness Ra is preferably 12.0 nm or more, more preferably 14.0 nm or more. The larger the surface roughness Ra becomes, the better transfer properties the sinter bonding layer 2 can achieve to the semiconductor chip. The surface roughness Ra is preferably 40.0 nm or less, more preferably 25.0 nm or less, further preferably 20.0 nm or less. The smaller the surface roughness Ra becomes, the better transfer properties the sinter bonding layer 2 can achieve to the semiconductor chip. Further, the substrate layer 1 can be more suppressed from being lifted from the sinter bonding layer 2.

The surface roughness Ra can be adjusted by, for example, changing an average particle size of the sinterable particles mixed into a varnish when the sinter bonding layer 2 is fabricated. Specifically, the surface roughness Ra can be more easily adjusted to 10.5 nm or more and 90.0 nm or less by setting the average particle size (D50) of the sinterable particles to preferably 0.01 µm or more and 10.0 µm or less, more preferably 0.05 µm or more 3.0 µm or less. Further, the surface roughness Ra can be adjusted by, for example, changing conditions for attaching (conditions for pressing treatment of) the sinter bonding layer 2 and the substrate layer 1 to each other when the sinter bonding sheet 10 is produced. Specifically, the surface roughness Ra can be more easily adjusted to 10.5 nm or more and 90.0 nm or less by setting pressure to preferably 0.1 MPa or more and 10.0 MPa or less, more preferably 0.5 MPa or more and 3.0 MPa or less in the pressing treatment. Alternatively, the surface roughness Ra can be more easily adjusted to 10.5 nm or more and 90.0 nm or less by setting a temperature to preferably 30 °C or more and 150 °C or less, more preferably 70 °C or more and 100 °C or less in the pressing treatment. Further alternatively, the surface roughness Ra can be more easily adjusted to 10.5 nm or more and 90.0 nm or less by employing continuous roll pressing treatment for the pressing treatment and setting a continuous feeding speed to preferably 0.1 m/min or more and 3.0 m/min or less, more preferably 0.5m/min or more and 2.5 m/min or less. A method for producing the sinter bonding sheet 10 will be later described in detail.

### [Method for measuring surface roughness Ra of sinter bonding layer]

The surface roughness Ra of the sinter bonding layer 2 is measured as follows. An electron microscope observation image (SEM observation image at a magnification of 50,000 times) in cross section of a sinter bonding layer cut in its thickness direction is obtained. Using image analysis software (e.g., product name "ImageJ"), the image is subj ected to drawing processing along unevenness of the surface, and the obtained drawn curve (roughness curve) is used to obtain its average line. A reference length (L) is set along a direction of the average line. Absolute values of deviations from the average line extending along the set reference length (L) to the drawn curve are summed. The average value of the total value is determined as the surface roughness Ra (arithmetic average roughness). As the reference length (L), a specific value of 2.0 µm or more and 5.0 µm or less is employed. The surface roughness Ra can be obtained according to JIS B 0601 (1994) and JIS B 0031 (1994).

The conductive metal contained in the sinterable particles is a metal having an electrical conductivity of 100 [µS/cm] or more (10⁶ [S/m] or more) as measured according to JIS K 0130 (2008). Examples of the conductive metal include gold, silver, copper, palladium, tin, and nickel. The conductive metal can be an alloy of two or more metals selected from the group consisting of gold, silver, copper, palladium, tin, and nickel. The sinterable particles can include a metal oxide such as silver oxide, copper oxide, palladium oxide, or tin oxide.

In this embodiment, the sinterable particles preferably include at least one selected from the group consisting of silver, copper, silver oxide, and copper oxide. This configuration can achieve better bonding properties for bonding the semiconductor element to the board via the individual piece of the sinter bonding layer 2 (individual piece 2" of the sinter bonding layer), as will be described later.

The sinterable particles preferably include, as the conductive metal, at least one of silver and copper. This configuration enables the sinter bonding layer 2 to achieve better thermal conductivity and better electrical conductivity.

In terms of oxidation resistance, the sinterable particles preferably include silver as the conductive metal. When the sinterable particles include silver, sintering treatment can be carried out suitably even in an air atmosphere. Specifically, the sintering treatment when bonding the semiconductor element such as the semiconductor chip B to, for example, the board can be suitably carried out in an air atmosphere. In contrast, when the sinterable particles include, for example, copper, the sintering treatment is preferably carried out in an inactive environment such as a nitrogen atmosphere to prevent the copper from being oxidized.

The sinterable particles can include a metal oxide. For example, the sinterable particles can be formed of metal particles with their surface portions transformed into a metal oxide.

For example, the sinterable particles can each have a core-shell structure having a core portion and a shell portion covering the core portion. The core portion can include, as the main component, at least one of silver and copper. The shell portion can include, as the main component, gold, silver, silver oxide, or copper oxide. For example, the sinterable particles can be formed of silver particles with their surfaces at least partially covered with silver oxide, or can be formed of copper particles with their surfaces at least partially covered with copper oxide. More specifically, the particles made of a plurality of kinds of metal can each be, for example, a particle having a core portion made of nickel, copper, silver, aluminum, or the like and a shell portion at least partially covering a surface of the core portion and made of gold, silver, copper, or the like.

In addition, examples of the sinterable particles include composite particles including a metal and a material other than the metal. Examples of the composite particles include particles each having a core part formed of, for example a resin particle, and a surface part at least partially covering a surface of the core part and made of a metal such as nickel or gold. The core part can be made of a carbon material such as carbon black or a carbon nanotube.

The metal particles as the sinterable particles can be subjected to surface treatment (e.g., silane coupling treatment). Examples of the surface treatment agent for the metal particles include a fatty acid-based coating agent, an amine-based coating agent, and an epoxy-based coating agent. For example, employed can be metal particles with their surfaces subjected to surface treatment by a fatty acid, which are also the above composite particles.

When the sinterable particles include silver, more specifically, when the sinterable particles are silver particles, the silver particles can include a silver element and other elements being inevitable impurity elements (e.g., metal elements). As the silver particles, those silver particles having their surfaces treated with a coating agent (hereinafter possibly referred to as coating agent treated silver particles) are preferable in terms of the following aspects. Use of the coating agent treated silver particles as the sinterable particles can further increase affinity between the organic binder and the sinterable particles in the sinter bonding layer 2 before sintering treatment. This configuration can more sufficiently disperse the sinterable particles in the sinter bonding layer 2 before sintering treatment. As will be described later on the production of a semiconductor device, the sintering treatment for the sinter bonding layer 2 at a certain temperature or higher at least partially eliminates the organic binder from the sinter bonding layer 2.

Only one kind of the aforementioned sinterable particles can be employed, or two or more kinds of these can be employed in combination.

The sinterable particles have, for example, a needle shape, a thread shape, a spherical shape, or a plate shape (including a scale shape). Among these shapes, a spherical shape is preferable. The sinterable particles having a spherical shape can be more favorably dispersed in a later-described varnish for obtaining the sinter bonding layer 2.

The sinterable particles are sintered to each other by the sintering treatment in which heating is carried out to a certain temperature. The sinterable particles are particles each having at least a part made of the conductive metal and fixed to each other when heated at a certain temperature. Thus, a heat transmission path is formed by the sintering treatment inside the sinter bonding layer 2. In particular, the heat transmission path is formed in a thickness direction of the sinter bonding layer 2. This enables the sinter bonding layer 2 to have a relatively high heat conductivity (heat dissipation).

The sinterable particles can be sinterable at a heating temperature of 400 °C or less. In other words, employed can be those sinterable particles with necking found on their outer surfaces when heated at a temperature of 400 °C or less. The sinterable particles are preferably sinterable at a heating temperature of 300 °C or less.

The temperature at which the sinterable particles are sintered can be measured using a thermogravimetric and differential thermal analyzer. Specifically, the measurement is carried out using a thermogravimetric and differential thermal analyzer (for example, the differential thermal balance TG8120 manufactured by Rigaku Corporation) under the following conditions. A Tg curve and a DTA curve are obtained by the measurement. The temperature at the largest peak of the DTA curve found near a portion of the Tg curve beginning to decline is defined as the sintering temperature of the sinterable particles.

### <Measurement conditions>

- Temperature rising rate: 10 °C/min
- Measurement atmosphere: Air
- Measurement temperature range: Ordinary temperature (23 ± 2 °C) to 500 °C

The sinterable particles including, as the conductive metals, gold, silver, copper, palladium, tin, or nickel, or an alloy thereof are sinterable at a heating temperature of 400 °C or less.

The average particle size of the sinterable particles is preferably 0.01 µm or more, more preferably 0.05 µm or more. This configuration enables the sinterable particles to have better dispersibilty in the later-described varnish for obtaining the sinter bonding layer 2. Thus, the sinter bonding layer 2 with the sinterable particles sufficiently dispersed therein can be prepared from the varnish. The average particle size of the sinterable particles is preferably 10 µm or less, more preferably 5 µm or less. This configuration enables the sinter bonding layer 2 to have a flatter and smoother surface.

The average particle size of the sinterable particles can be determined by observing a cross-sectional surface of the sinter bonding layer 2 using a scanning electron microscope (SEM). Specifically, the average particle size can be determined according to the steps below, which are to be performed for the sinter bonding layer 2 before sintering treatment (described later):
(1) A piece of the sinter bonding layer 2 having a thickness of 50 µm (0.05 mm) and extending to have a size of 10 mm × 10 mm in a plane direction perpendicular to the thickness direction is prepared as a measurement sample.
(2) The cross-sectional surface obtained by cutting the measurement sample is subjected to scrubbing treatment, followed by conductive treatment to fabricate a sample for SEM observation.
(3) An SEM observation image (at a magnification of 10,000 times or 100,000 times according to the size of each particle) is obtained at an acceleration voltage of 3 kV.
(4) The SEM observation image is subjected to image analysis to identify each particle. Those particles present in an end portion of the observation image are not observed. The circle equivalent diameter of each identified particle is calculated. The circle equivalent diameter is a diameter of a true circle calculated from the area of each particle assuming that the particle has a true circular shape.

The sinter bonding layer 2 includes preferably 70 mass % or more, more preferably 75 mass % or more, further preferably 80 mass % or more, of the sinterable particles. The sinter bonding layer 2 includes preferably 99 mass % or less, more preferably 98 mass % or less, further preferably 97 mass % or less, of the sinterable particles. The content percentage of the sinterable particles falling within the above range enables the sinter bonding layer 2 after the sintering treatment to exert sufficiently reliable bonding properties when the sinterable particles are sintered to each other through the sintering treatment to bond the semiconductor element such as the semiconductor chip B to the board.

The content percentage of the sinterable particles in the sinter bonding layer 2 can be calculated from the measured ash content remaining after the sinter bonding layer 2 is burnt. For example, the measurement can be performed according to the steps below using, for example, a thermogravimetric analyzer (e.g., TG209F1). The measurement using the thermogravimetric analyzer is preferably performed in a nitrogen gas flow.
(1) The measurement sample of the sinter bonding layer 2 weighing about 50 mg is heated from room temperature (23 ± 2 °C) to 650 °C.
(2) The temperature is kept at 650 °C for 30 minutes to thereby thermally decompose the organic binder in the measurement sample.
(3) The mass ratio of the remaining component (ash content) to the weighed value (about 50 mg) of the measurement sample is calculated.

In this embodiment, it is preferable that the sinter bonding layer 2 include, as the organic binder, a first organic binder and a second organic binder having a smaller molecular weight than that of the first organic binder.

The first organic binder is preferably a thermally decomposable polymer binder. The thermally decomposable polymer binder is a binder thermally decomposable by sintering treatment. The thermally decomposable polymer binder also has a function to have the sinter bonding layer 2 held in a sheet shape before sintering treatment. In terms of more sufficiently exerting such a function, the thermally decomposable polymer binder is preferably solid at ordinary temperature (23 ± 2 °C). Examples of the thermally decomposable polymer binder include a polycarbonate resin and an acrylic resin. The sinter bonding layer 2 preferably includes, as the first organic binder, at least one of the polycarbonate resin and the acrylic resin. The sinter bonding layer 2 can include only the polycarbonate resin as the first organic binder.

Examples of the polycarbonate resin include an aliphatic polycarbonate having no aromatic structure such as a benzene ring but only an aliphatic chain between carbonate esters (-O-CO-O-) of the main chain, and an aromatic polycarbonate having an aromatic structure between carbonate esters (-O-CO-O-) of the main chain. Examples of the aliphatic polycarbonate include polyethylene carbonate and polypropylene carbonate. Examples of the aromatic polycarbonate include a polycarbonate with its main chain having a bisphenol A structure.

Examples of the acrylic resin include a (meth)acrylate alkyl ester polymer with its linear or branched alkyl portion having 4 to 18 carbon atoms. It should be noted that the term "(meth)acrylate" includes both "acrylate" and "methacrylate".

Examples of the alkyl group (alkyl portion) of the (meth)acrylate ester include a methyl group, an ethyl group, a propyl group, an isopropyl group, an n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, and an octadecyl group.

The acrylic resin can include, in its molecule, a polymerization unit derived from a different monomer other than the above (meth)acrylate ester. Examples of the different monomer include a carboxy group-containing monomer, an acid anhydride monomer, a hydroxy group-containing monomer, a sulfonic acid group-containing monomer, and a phosphoric acid group-containing monomer.

Examples of the carboxy group-containing monomer include acrylic acid, methacrylic acid, carboxyethyl acrylate, carboxypentyl acrylate, itaconic acid, maleic acid, fumaric acid, and crotonic acid. Examples of the acid anhydride monomer include maleic anhydride and itaconic anhydride. Examples of the hydroxy group-containing monomer include (meth)acrylate 2-hydroxyethyl, (meth)acrylate 2-hydroxypropyl, (meth)acrylate 4-hydroxybutyl, (meth)acrylate 6-hydroxyhexyl, (meth)acrylate 8-hydroxyoctyl, (meth)acrylate 10-hydroxydecyl, (meth)acrylate 12-hydroxylauryl, and (meth)acrylate 4-(hydroxymethyl)cyclohexylmethyl. Examples of the sulfonic acid group-containing monomer include styrene sulfonic acid, allyl sulfonic acid, 2-(meth)acrylamide-2-methylpropane sulfonic acid, (meth)acrylamide propane sulfonic acid, sulfopropyl (meth)acrylate, and (meth)acryloyloxynaphthalene sulfonic acid. Examples of the phosphoric acid group-containing monomer include 2-hydroxyethyl acryloyl phosphate.

The second organic binder that can be included in the sinter bonding layer 2 is preferably a highly volatile binder. The highly volatile binder is a binder component that completes its weight reduction (i.e., that is entirely desorbed to a weight of 0%) at a lower temperature than that for the first organic binder (e.g., the thermally decomposable polymer binder) when measured by thermogravimetric analysis (TGA).

In this embodiment, the highly volatile binder is preferably in a liquid state having a viscosity of 1 × 10⁵ Pa·s or less at 23 °C. Such a viscosity is measured using a dynamic viscoelasticity measuring device (device name "HAAKE MARS III" manufactured by Thermo Fisher Scientific K.K.). Specifically, the viscosity is measured using parallel plates as a jig each having a diameter of 20 mm and disposed to have a gap therebetween of 100 µm, at a shear rate of 1 S⁻¹ in shearing by rotation.

Examples of the highly volatile binder include terpene alcohols, alcohols other than the terpene alcohols, alkylene glycol alkyl ethers, and ethers other than the alkylene glycol alkyl ethers.

Examples of the terpene alcohols include isobornyl cyclohexanol, cytronellol, geraniol, nerol, carveol, and α-terpineol. Examples of the alcohols other than the terpene alcohols include pentanol, hexanol, heptanol, octanol, 1-decanol, ethylene glycol, diethylene glycol, propylene glycol, butylene glycol, and 2,4-diethyl-1,5-pentanediol. Examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol methyl ether, triethylene glycol dimethyl ether, triethylene glycol butyl methyl ether, propylene glycol propyl ether, dipropylene glycol methyl ether, dipropylene glycol ethyl methyl ether, dipropylene glycol propyl ether, dipropylene glycol butyl ether, and tripropylene glycol dimethyl ether. Examples of the ethers other than the alkylene glycol alkyl ethers include ethylene glycol ethyl ether acetate, ethylene glycol butyl ethyl acetate, diethylene glycol ethyl ether acetate, diethylene glycol butyl ethyl acetate, and dipropylene glycol methyl ether acetate.

These highly volatile binders can be individually used, or two or more of them can be used in combination.

As the highly volatile binder, the terpene alcohols are preferable, and isobornyl cyclohexanol among the terpene alcohols is more preferable, in terms of its stability at ordinary temperature.

Isobornyl cyclohexanol is referred to also as 4-[1,7,7-trimethylbicyclo[2.2.1]heptane-2-yl]cyclohexanol. Isobornyl cyclohexanol has a boiling point falling within a range of 308 °C or more and 318 °C or less. Isobornyl cyclohexanol has a vapor pressure at 25 °C of 0.00003 mmHg. Isobornyl cyclohexanol has characteristic physical properties as follows. Specifically, isobornyl cyclohexanol has properties that, when heated from ordinary temperature (23 ± 2 °C) to 600 °C in a 200 mL/min nitrogen gas flow at a temperature rising rate of 10 °C/min, isobornyl cyclohexanol begins significantly reducing its mass at 100 °C or more, and is volatilized and eliminated (i.e., no further mass reduction can be found) at 245 °C. Further, isobornyl cyclohexanol has properties of having a viscosity as extremely high as 1000000 mPa·s at 25 °C but having a viscosity as relatively low as 1000 mPa·s at 60 °C. The mass reduction is a value obtained when the mass reduction ratio at a temperature at which the measurement begins (i.e., ordinary temperature) is 0%. As described above, isobornyl cyclohexanol having this extremely high viscosity at 25 °C enables the sinter bonding layer 2 to easily maintain its sheet shape at ordinary temperature. In contrast, isobornyl cyclohexanol at 60 °C has the relatively low viscosity as above and has tackiness. That is, the sinter bonding layer 2 including isobornyl cyclohexanol can sufficiently maintain its sheet shape at ordinary temperature and have tackiness at 60 °C or higher. A semiconductor element is temporarily fixed to an adherend such as a board via the sinter bonding layer 2 at a temperature of generally 60 to 80 °C. At such a temperature, isobornyl cyclohexanol has tackiness for the reason above. Thus, the sinter bonding layer 2 including isobornyl cyclohexanol as the second organic binder has better temporary fixing properties to an adherend such as a board. In other words, it can be further suppressed after the semiconductor element is temporarily fixed to the adherend that the attached semiconductor element is displaced or that the sinter bonding layer 2 is lifted from the adherend.

The sinter bonding layer 2 can include 1 mass % or more, 2 mass % or more, 3 mass % or more of the organic binder. The sinter bonding layer 2 includes preferably 3 mass % or more, more preferably 5 mass % or more of the organic binder. The sinter bonding layer 2 can include 40 mass % or less, 35 mass % or less, 30 mass % or less of the organic binder. The sinter bonding layer 2 includes preferably 20 mass % or less, more preferably 10 mass % or less of the organic binder.

When the sinter bonding layer 2 includes the first organic binder and the second organic binder as the organic binder, the proportion (in %) of the first organic binder to the total of the first organic binder and the second organic binder is preferably 5 mass % or more and 60 mass % or less, more preferably 10 mass % or more and 50 mass % or less, further preferably 15 mass % or more and 40 mass % or less. In the sinter bonding layer 2, the content of the second organic binder can be larger than the content of the first organic binder.

The sinter bonding layer 2 includes preferably 0.01 mass % or more, more preferably 0.05 mass % or more, further preferably 0.10 mass % or more, particularly preferably 0.20 mass % or more, of the first organic binder. The sinter bonding layer 2 includes preferably 20.0 mass % or less, more preferably 10.0 mass % or less, further preferably 7.5 mass % or less, particularly preferably 5.0 mass % or less, of the first organic binder.

The sinter bonding layer 2 includes preferably 0.5 mass % or more, more preferably 1.0 mass % or more, further preferably 1.5 mass % or more, particularly preferably 2.0 mass % or more, of the second organic binder. The sinter bonding layer 2 includes preferably 20.0 mass % or less, more preferably 15.0 mass % or less, further preferably 10.0 mass % or less, of the second organic binder.

The sinter bonding layer 2 has, for example, a structure with a plurality of layers layered on each other. The sinter bonding layer 2 can have the plurality of layers integrated with each other to thereby form a single-layered structure with no interfaces between the plurality of layers.

In this embodiment, the sinter bonding layer 2 has a thickness of preferably 5 µm or more, more preferably 10 µm or more. The thickness of the sinter bonding layer 2 can be 300 µm or less, can be 200 µm or less, can be 100 µm or less. The thickness of the sinter bonding layer 2 falling within the above range enables the organic binder included in the sinter bonding layer 2 to be easily volatilized or decomposed when the sinterable particles are sintered to each other through the sintering treatment to bond the semiconductor element such as the semiconductor chip B to the board (i.e., during sintering treatment). This configuration allows voids to hardly remain in the sinter bonding layer and allows the sinter bonding layer 2 to sufficiently exert its performance reliability.

The thickness of the sinter bonding layer 2 is calculated by measuring the thickness thereof at any five positions selected at random using a dial gauge (model R-205 manufactured by PEACOCK), followed by arithmetically averaging these measured thicknesses.

### [Substrate layer of sinter bonding sheet]

In this embodiment, the substrate layer 1 of the sinter bonding sheet 10 functions as a support body of the sinter bonding sheet 10. The substrate layer 1 is formed of, for example, a plastic film. The substrate layer 1 can function as a coating substrate to which the varnish (to be discussed in detail later) is applied to form the sinter bonding layer 2. The substrate layer 1 can be a general release liner.

Examples of the material of the plastic film include a polyolefin resin, a polyester resin such as a polyethylene terephthalate resin, a polyurethane resin, a polycarbonate resin, a polyether ether ketone resin, a polyimide resin, a polyether imide resin, a polyamide resin, a wholly aromatic polyamide resin, a polyvinyl chloride resin, a polyvinylidene chloride resin, a polyphenyl sulfide resin, an aramid resin, a fluororesin, a cellulose-based resin, and a silicone resin. The substrate layer 1 can be formed of a single material, or can be formed of two or more materials.

Examples of the polyolefin resin include a low-density polyethylene resin, a linear low-density polyethylene resin, a middle-density polyethylene resin, a high-density polyethylene resin, an ultralow-density polyethylene resin, a random copolymer polypropylene resin, a block copolymer polypropylene resin, a homopolypropylene resin, a polybutene resin, a polymethylpentene resin, an ethylene-vinyl acetate copolymer resin, an ionomer resin, an ethylene-butene copolymer resin, and an ethylene-hexene copolymer resin. Examples of the polyester resin include a polyethylene terephthalate resin, a polyethylene naphthalate resin, and a polybutylene terephthalate resin.

The substrate layer 1 can have a single-layered structure, or can have a multilayered structure. The single-layered structure means a structure formed of a single material. For example, the substrate layer 1 in which two or more layers each made of a single material are layered on each other has a single-layered structure. **In** contrast, the substrate layer 1 in which two or more layers respectively made of different materials are layered on each other has a multilayered structure.

When the substrate layer 1 is a plastic film, the substrate layer 1 can be a non-oriented film, or can be an oriented film. The oriented film can be a uniaxially-oriented film, or can be a biaxially-oriented film. The substrate layer 1 can be a release liner whose surface in contact with the sinter bonding layer 2 is subjected to release treatment. One surface of the substrate layer 1 in contact with the sinter bonding layer 2 is, for example, coated with a releasing agent. In this case, the individual piece of the sinter bonding layer 2 (i.e., individual piece 2" of the sinter bonding layer) can be easily separated from the one surface of the substrate layer 1 (i.e., release liner) in producing the semiconductor device.

The thickness of the substrate layer 1 is preferably 10 µm or more, more preferably 20 µm or more, further preferably 30 µm or more. The substrate layer 1 having a thickness of 10 µm or more can suppress the force externally applied (e.g., compression force or shear force transmitted from a conveying roll) from being transmitted to the sinter bonding layer 2 when the sinter bonding sheet 10 is in production. This configuration can suppress the sinter bonding layer 2 from being partially broken or partially dented by the force. Accordingly, this configuration can suppress a yield reduction of the sinter bonding sheet 10 during its production. The thickness of the substrate layer 1 is preferably 500 µm or less, more preferably 200 µm or less. The substrate layer 1 having a thickness of 500 µm or less can easily follow the sinter bonding layer 2 when the layered product of the substrate layer 1 and the sinter bonding layer 2 is rolled up, and can thus be more suppressed from being lifted from the sinter bonding layer 2. The thickness of the substrate layer 1 is measured in the same manner as in the thickness of the sinter bonding layer 2 as aforementioned.

The surface of the substrate layer 1 in contact with the sinter bonding layer 2 can have a surface roughness of, for example, 20 µm or less. The surface roughness of the substrate layer 1 is measured in the same manner as in the surface roughness Ra of the sinter bonding layer 2 described above.

The sinter bonding sheet 10 can be in a rolled state. The sinter bonding sheet 10 includes a roll core having a circular cylindrical shape around which the layered product of the substrate layer 1 and the sinter bonding layer 2 is wound. The roll core has a diameter of preferably 30 mm or more and 260 mm or less. The diameter of the roll core (rolling diameter) being 30 mm or more suppresses the curvature of the layered product from being too large, and can thus further prevent the sinter bonding layer 2 from cracking. The roll core can have a solid circular cylindrical shape or a hollow circular cylindrical shape (tubular shape). In the latter case, the diameter of the roll core having a tubular shape refers to an outer diameter of the roll core. When the layered product is wound around the roll core having the above diameter into a rolled state, the entire layered product (particularly a portion close to the roll core) is subjected to bending force. This easily causes separation between the substrate layer 1 and the sinter bonding layer 2, resulting in the substrate layer 1 easily lifted from the sinter bonding layer 2. Even in such a state, the substrate layer 1 of the sinter bonding sheet 10 of this embodiment in a rolled state is suppressed from being lifted from the sinter bonding layer 2 as the surface of the sinter bonding layer 2 in contact with the substrate layer 1 has a surface roughness Ra falling within the above numerical range.

Next, a description will be given on a method for producing the aforementioned sinter bonding sheet.

A method for producing the sinter bonding sheet includes:
a step of forming a plurality of intermediates of the sinter bonding layer each into a sheet shape by volatilizing a solvent from the varnish including the sinterable particles, the organic binder, and the solvent (e.g., organic solvent) (hereinafter referred to as sheet-shaped intermediate forming step); and
a step of applying press treatment to the sinter bonding layer fabricated by attaching the plurality of intermediates to each other (hereinafter referred to as press treatment step).

In the method for producing the sinter bonding sheet, the sinter bonding sheet can be produced continuously (hereinafter referred to also as continuous production method). In the continuous production method, for example, the substrate layer 1 (e.g., release liner) having an elongated sheet shape is used. The substrate layer is unwound from the rolled substrate layer 1 (roll body of the substrate layer) and moved to one side in a longitudinal direction, during which a sheet-like intermediate 2' is continuously formed on at least one surface of the substrate layer 1. When the sinter bonding layer 2 is continuously formed, the sheet-like intermediate 2' is formed on the substrate layer while the solvent is volatilized from the varnish applied on the substrate layer, to fabricate a layered body of the substrate layer 1 and the sheet-like intermediate 2'. A plurality of the intermediates 2' are attached to each other while such a layered body is further moved to the one side, and are further subjected to, for example, press treatment. In the above method for producing the sinter bonding sheet, sinter bonding sheets each having a flat plate shape can be produced one by one (hereinafter referred to also as sheet production method). In the sheet production method, for example, the substrate layer 1 (e.g., release liner) having a rectangular sheet shape is used. The sheet-like intermediate 2' is formed on at least one surface of the substrate layer 1 to fabricate a layered body of the substrate layer 1 and the sheet-like intermediate 2'. For example, two layered bodies are prepared and disposed to bring their intermediates 2' into contact with each other, and the layered intermediates 2' are subjected to, e.g., press treatment.

In the method for producing the sinter bonding sheet, a plurality of (two, or three or more) sheet-like intermediates can be attached to each other. Hereinafter, a description in detail will be given on an example of the method for producing the sinter bonding sheet by the continuous production method in which the plurality of (two) sheet-like intermediates are attached to each other. A description will be given on producing equipment for carrying out the continuous production method, and steps in the continuous production method.

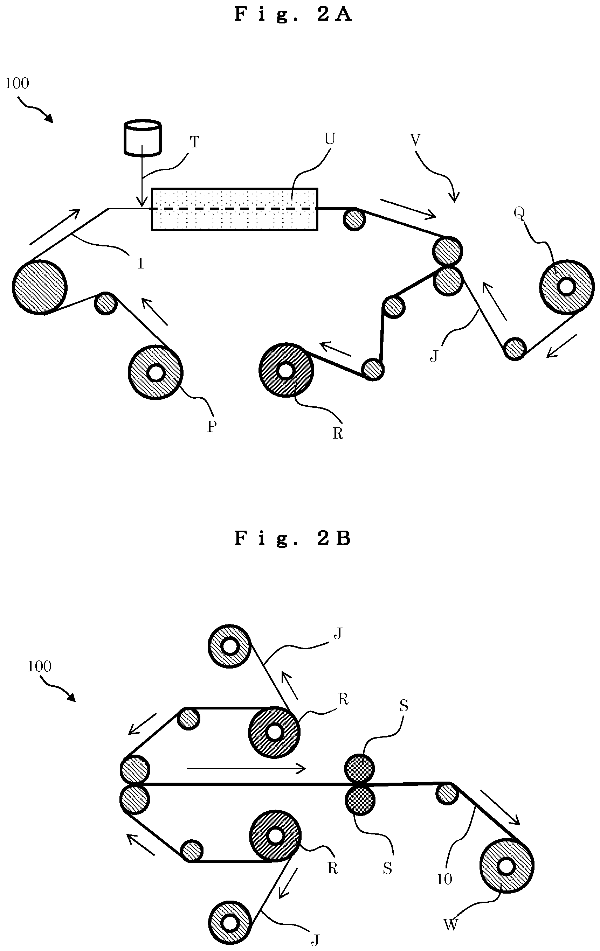

As shown in, for example, Fig. 2A, producing equipment 100 for carrying out the continuous production method includes a first device configured to fabricate the intermediate 2' for the sinter bonding layer having a sheet shape. The first device includes: a roll body P formed by rolling up the elongated substrate layer 1 (e.g., release liner); a coater T configured to apply the varnish supplied from a tank to one surface of the elongated substrate layer 1 fed from the roll body P; a dryer U for volatilizing the solvent from the applied varnish; another roll body Q formed by rolling up an elongated protective sheet J (e.g., release liner); a covering part V for covering the sheet-like intermediate 2' on the substrate layer 1 that has passed through the dryer U with the elongated protective sheet J fed from the roll body Q; and a roll body R for rolling up the layered body with the sheet-like intermediate 2' disposed between the substrate layer 1 and the protective sheet J. In the continuous production method, the substrate layer 1 is continuously unwound to the one side in the longitudinal direction from the roll body P formed by rolling up the elongated substrate layer 1 (e.g., release liner). At the coater T, the varnish supplied from the tank is applied on the one surface of the substrate layer 1 fed from the roll body P. At the dryer U, the solvent is volatilized from the varnish applied into a layer. The volatilization is carried out by, for example, heating or decompression. Further, at the covering part V, the sheet-like intermediate 2' formed on the substrate layer 1 with the solvent volatilized is covered with the protective sheet J fed from the other roll body Q. Then, the roll body R of the layered body with the substrate layer 1 and the protective sheet J disposed on the respective surfaces of the sheet-like intermediate 2 is obtained. Since the sheet-like intermediate 2' is not subjected to press treatment at this stage, the surface of the sheet-like intermediate 2' does not have the above-determined surface roughness.

As shown in, for example, Fig. 2B, the producing equipment 100 for carrying out the continuous production method includes a second device configured to attach two intermediates 2' of the respective sheet-like sinter bonding layers. The second device includes two roll bodies R described above. The protective sheet J is used to prevent foreign matters or the like from adhering to the surface of the sheet-like intermediate 2' when each of the roll bodies R is moved from the first device to the second device. The second device includes a press treatment part S configured to allow the two sheet-like intermediates 2' fed from the respective two roll bodies R to be attached together and subjected to press treatment. The second device further includes a winding part W configured to wind the sinter bonding sheet 10 with the sinter bonding layer formed through press treatment. In the continuous production method, the protective sheet J of each of the layered bodies is removed while the layered bodies are unwound from the respective two roll bodies R. The exposed surfaces of the sheet-like intermediates 2' with the protective sheets J removed are attached together, and a layered product with the two attached intermediates 2' sandwiched between the two substrate layers 1 is conveyed to a press treatment part S. The two intermediates 2' attached together are subjected to press treatment by the press treatment part S to form the sinter bonding layer 2, and the sinter bonding sheet 10 after the press treatment is wound around the winding part W.

In the example above, the producing equipment for carrying out the continuous production method includes the first device and the second device, and is configured to once wind the layered bodies each having the sheet-like intermediate 2'. The configuration can also be such that the producing equipment for carrying out the continuous production method includes a device configured to fabricate the intermediates 2' of the elongated sheet-like sinter bonding layer respectively on one surfaces of the substrate layers 1 and attach the intermediates 2' together without being covered with the protective sheet, followed further by press treatment, and configured to perform all these steps sequentially.

The varnish to be used in the continuous production method is prepared by, for example, mixing the sinterable particles, the organic binder, and the organic solvent together to disperse the sinterable particles in the organic solvent, and dissolving the organic binder in the organic solvent.

As the organic solvent, for example, alcohols such as ethanol or ketones such as methyl ethyl ketone (MEK) can be used.

The mixing temperature for preparing the varnish is not particularly limited, and is, for example, 5 °C or more and 70 °C or less. No method for mixing the varnish is particularly limited, and any mixing method using a general stirrer can be employed.

The solid content concentration of the varnish is preferably 60 mass % or less, more preferably 58 mass % or less, further preferably 55 mass % or less. The solid content refers to the component obtained by removing the organic solvent from the varnish, and is, for example, the total content of the sinterable particles and the organic binder. The solid content concentration of the varnish can be 30 mass % or more, 40 mass % or more, 50 mass % or more, 52 mass % or more.

The varnish has a viscosity at 23 °C of preferably 1.0 [Pa·s] or more and 7.0 [Pa·s] or less, more preferably 2.0 [Pa·s] or more and 5.0 [Pa·s] or less. Such a viscosity is measured using an E-type viscometer (e.g., device name "RE-85" manufactured by Toki Sangyo Co., Ltd). Specifically, a "1°34' × R24" cone rotor as a jig is used with a measurement sample in an amount of 1.1 mL at a rotation speed of 1.0 rpm for the measurement of the viscosity.

In the sheet intermediates forming step in the continuous production method, the varnish is applied on the substrate layer 1 at a certain thickness to form a coating film. Subsequently, the organic solvent is volatilized from the coating film.

The varnish can be applied using a general coating device. As a coating method, employed can be, for example, a die coating method, a gravure coating method, a reverse coater coating method, or a blade coating method.

The organic solvent can be volatilized by heating or by decompression. When the organic solvent is volatilized by heating, heating treatment can be performed, for example, at a temperature of 100 °C or more and 150 °C or less for a minute or more and 10 minutes or less.

In the press treatment of the press treatment step in the continuous production method, for example, the sinter bonding layer made of the plurality of intermediates 2' is subjected to a pressure of 0.1 MPa or more and 10.0 MPa or less at a temperature of 30 °C or more and 150 °C or less while the substrate layer(s) is in abutting contact with one or both surfaces of the sinter bonding layer. Such a pressure refers to a pressure applied to the sinter bonding layer. The press treatment part S includes, for example, two pressure rollers, and is configured to rotate the two pressure rollers in directions opposite to each other with the two substrate layers 1 and the two intermediates 2' placed therebetween to thereby pressurize and convey the two substrate layers 1 and the two intermediates 2' in one direction. Also, the press treatment part S is configured to allow the pressurization to be carried out in a certain temperature environment. Thus, the press treatment part S is configured to apply the press treatment within a certain temperature range and a certain pressure range.

In the press treatment, a preferable temperature is 70 °C or more and 100 °C or less. A preferable pressure is 0.5 MPa or more and 3.0 MPa or less. In the press treatment, a speed at which the substrate layers and the sinter bonding layer are conveyed in the one direction is, for example, 0.1 [m/min] or more and 3.0 [m/min] or less, preferably 0.5 [m/min] or more and 2.5 [m/min] or less.

The sinter bonding sheet 10 wound around the winding part W after the press treatment can be stored in a rolled state. Alternatively, the sinter bonding sheet 10 in a rolled state can be unwound into a flat sheet shape and cut into pieces each having a desired size. A plurality of the cut pieces of the sinter bonding sheets 10 in a flat sheet shape can be stacked on each other for storage.

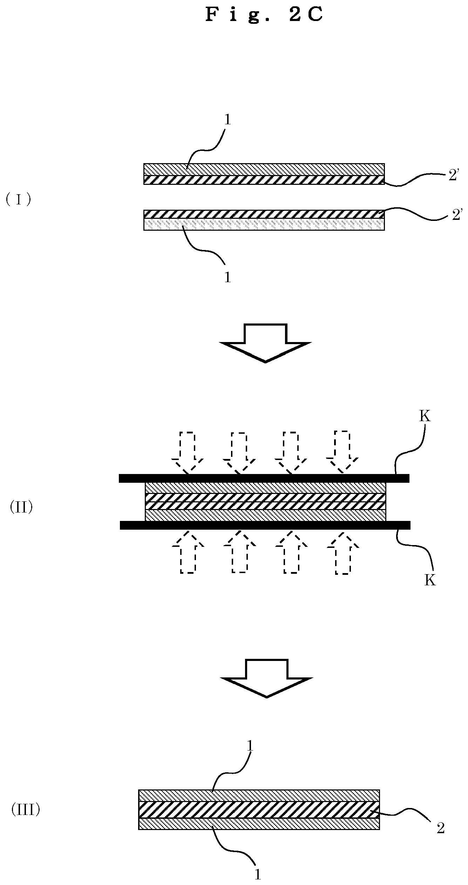

In the sheet production method in contrast to the above continuous production method, producing equipment including a flat plate press machine for press treatment can be used. The flat plate press machine includes, for example, two compressing flat plate members K. As shown in, for example, Fig. 2C, the sheet production method is carried out as follows:
(I) A varnish prepared in the same manner as above is applied to one surface of the substrate layer 1 (e.g., release liner), and the solvent is volatilized to form a sheet-like intermediate 2' (intermediate of the sinter bonding layer) on the one surface of the substrate layer 1. A layered sheet of the substrate layer 1 and the sheet-like intermediate 2' is thus fabricated. Then, two of the layered sheets thus fabricated are layered on each other to have their sheet-like intermediates 2' in contact with each other.
(II) Press treatment is applied to the two layered sheets layered on each other, using the flat plate press machine. Specifically, the two layered sheets are arranged between the above two compressing flat plate members K, and a distance between the two compressing flat plate members K is made small. As the temperature and pressure for the press treatment in the sheet production method, employed can be the same temperature and the same pressure as those for the press treatment in the continuous production method.
(III) A sinter bonding sheet having the substrate layers 1 disposed respectively on both surfaces of the sinter bonding layer 2 can be obtained.

The above description has been given in detail by taking, for example, the specific case where the two sheet-like intermediates 2' are attached together to fabricate the sinter bonding layer 2, but the sinter bonding layer 2 can be fabricated by attaching three or more sheet-like intermediates 2' together. In this case, the sinter bonding layer 2 can be fabricated by bonding two sheet-like intermediates 2' together as above, followed by further bonding another sheet-like intermediate 2' thereto.

### [Method for using sinter bonding sheet (method for producing semiconductor device)]

The sinter bonding sheet 10 produced as above can be used as, for example, a member for producing the semiconductor device. Next, a description will be given on one example of a method for producing a semiconductor device using the sinter bonding sheet 10 according to this embodiment, with reference to the drawings.

The method for producing the semiconductor device is carried out using, for example: a plurality of the semiconductor chips B; a board having a plurality of mounting areas on which the plurality of semiconductor chips B are to be respectively mounted; the sinter bonding sheet 10; and a pressing member used for temporarily fixing each of the plurality of semiconductor chips B to each corresponding one of the plurality of mounting areas.

A description hereinafter will be given by taking, for example, the case where the semiconductor chips B are mounted on the board such as a DBC (Direct Bonded Copper) board or an AMB (Active Metal Brazing) board using a collet A as the pressing member. Each of these boards includes a ceramic insulating layer D, and a copper die pad E and a copper thin layer F on the respective sides of the ceramic insulating layer D. The copper die pad E corresponds to the mounting areas of the semiconductor chips B.

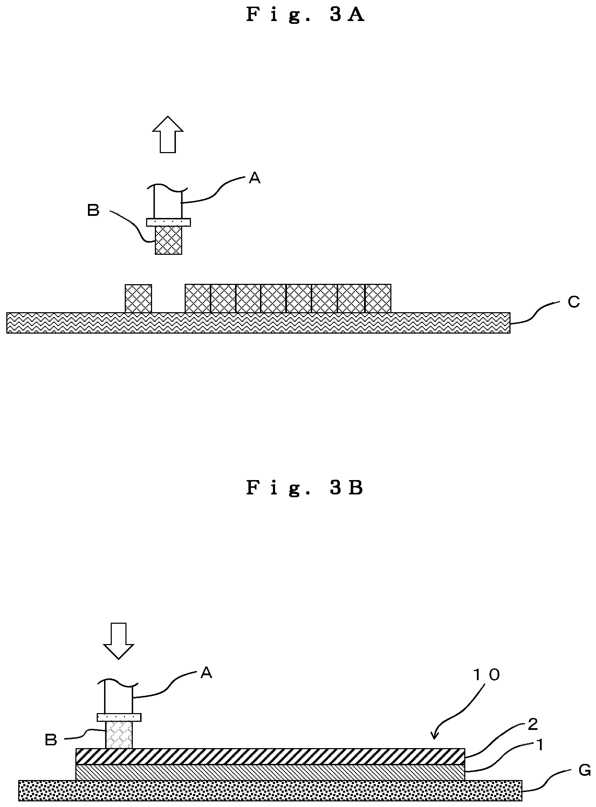

First, a semiconductor wafer is cut on a dicing tape C to obtain the plurality of semiconductor chips B out of the semiconductor wafer (see Fig. 3A). In other words, the semiconductor wafer is divided into a plurality of individual pieces to obtain the semiconductor chips B. Used as the dicing tape C can be any commercially available product.

Each of the obtained semiconductor chips B has, for example, a rectangular sheet shape. The semiconductor chip B has a thickness of, for example, 10 µm or more and 500 µm or less. The semiconductor chip B has a thickness of preferably 20 µm or more and 400 µm or less. The semiconductor chip B has an area of, for example, 0.01 mm² or more and 1000 mm² or less as viewed from one side of the thickness direction. Such an area is preferably 0.04 mm² or more and 500 mm² or less.

Next, as shown in Fig. 3B, the sinter bonding sheet 10 is placed on a first stage G to have the sinter bonding layer 2 located on an upper side of the substrate layer 1. Then, one semiconductor chip B is pressed at the sinter bonding layer 2 using the collet A to have the semiconductor chip B attached to a part of the sinter bonding layer 2. The pressure during the pressing is preferably 0.01 MPa or more and 10 MPa or less, more preferably 0.1 MPa or more and 5 MPa or less. The temperature of the collet A or the first stage G during the pressing is preferably 40 °C or more and 150 °C or less, more preferably 50 °C or more and 130 °C or less. The pressure for pressing the semiconductor chip B at the sinter bonding layer 2 falling within the above range, or the temperature of the collet A or the first stage G falling within the above range enables the semiconductor chip B with the individual piece 2" of the sinter bonding layer attached thereto to be favorably obtained when the collet A is lifted up, as will be subsequently described. The surface of the collet A in abutting contact with the semiconductor chip B has a shape and a size substantially corresponding to the shape and the size of the one semiconductor chip B as described above.

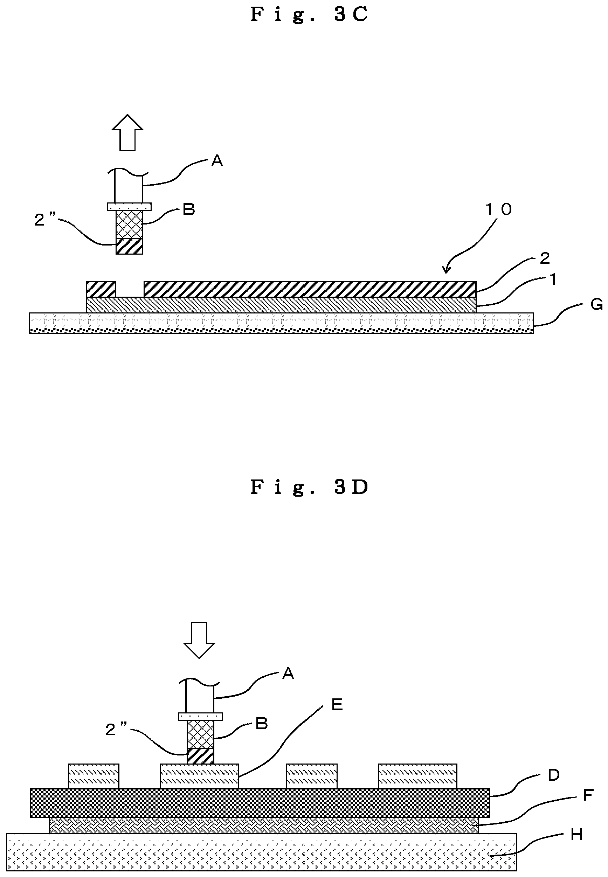

Next, the collet A is lifted up as shown in Fig. 3C. In so doing, the part of the sinter bonding layer 2 attached to the semiconductor chip B is lifted up together with the semiconductor chip B. In other words, the semiconductor chip B with the individual piece 2" of the sinter bonding layer adhering thereto is lifted up with the collet A. Thus, the semiconductor chip B with the individual piece of the sinter bonding layer 2 (also referred to as individual piece 2" of the sinter bonding layer) attached thereto is obtained. Since the surface of the individual piece 2" of the sinter bonding layer in contact with the substrate layer 1 has a surface roughness Ra of 10.5 nm or more and 90.0 nm or less as described above, the individual piece 2" of the sinter bonding layer is separated from the one surface of the substrate layer 1 and easily lifted up together with the semiconductor chip B. That is, good transfer properties can be exhibited.

Next, the board (the ceramic insulating layer D, the copper die pad E, and the copper thin layer F) is placed on a second stage H (see Fig. 3D). Then, as shown in Fig. 3D, the collet A held at any temperature within a range of 25 °C or more and 150 °C or less is caused to descend in a vertical direction to bring the individual piece 2" of the sinter bonding layer adhering to the semiconductor chip B into abutting contact with the copper die pad E. Subsequently, the semiconductor chip B is pressed downward at the copper die pad E using the collet A. The semiconductor chip B is thereby temporarily fixed to the copper die pad E via the individual piece 2" of the sinter bonding layer (see Fig. 3D). The pressure at which the semiconductor chip B is pressed at the copper die pad E is preferably 0.01 MPa or more and 50 MPa or less, more preferably 0.1 MPa or more and 30 MPa or less.

The board as an adherend of the individual piece 2" of the sinter bonding layer can be a lead frame. A general lead frame can be used as the lead frame. For example, a lead frame formed of a Cu frame plated with Ag, or a lead frame formed of a Cu frame plated with Ni, Pd, and Au in this order (Palladium Pre-Plated Lead Frame; Pd-PPF) can be employed.

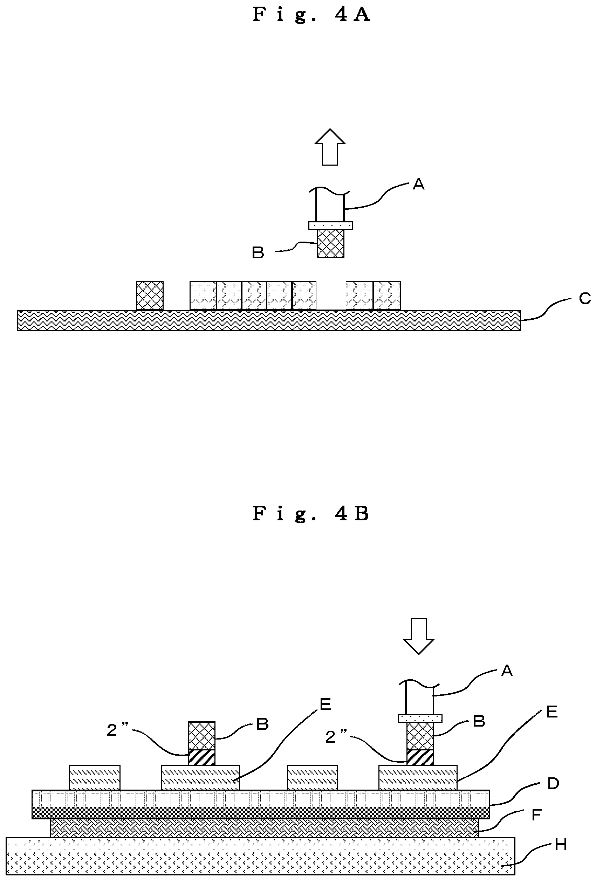

The operations above are carried out to temporarily fix the one semiconductor chip B to the copper die pad E, followed by repeatedly carrying out the same operations. Specifically, as shown in Fig. 4A, another semiconductor chip B out of the plurality of semiconductor chips B is separated and lifted up from the dicing tape C using the collet A. Next, similarly to Fig. 3B, the other semiconductor chip B is pressed at the sinter bonding layer 2 of the sinter bonding sheet 10 using the collet A. Further, similarly to Fig. 3C, the collet A is drawn up to separate and lift up the other semiconductor chip B with the individual piece 2" of the sinter bonding layer adhering thereto from the substrate layer 1. Subsequently, while the collet A is held at a temperature similar to that above, the other semiconductor chip B with the individual piece 2" of the sinter bonding layer adhering thereto is brought into abutting contact with another mounting area in the copper die pad E. Further, the other semiconductor chip B is pressed downward at the copper die pad E using the collet A, as shown in Fig. 4B. The other semiconductor chip B is thereby temporarily fixed to the other mounting area in the copper die pad E via the individual piece 2" of the sinter bonding layer (see Fig. 4B). These operations are sequentially carried out in a repeated manner until all those semiconductor chips B to be temporarily fixed to the copper die pad E are disposed on the copper die pad E.

When each of the semiconductor chips B is temporarily fixed, the collet A can be heated to a temperature at which the sinterable particles included in the individual piece 2" of the sinter bonding layer can be sintered. The sinterable particles included in the individual piece 2" of the sinter bonding layer can be thereby subjected to primary sintering treatment. In other words, the sintering treatment can be partially carried out for the individual piece 2" of the sinter bonding layer immediately after the temporary fixing as above.

When the sinterable particles included in the individual piece 2" of the sinter bonding layer can be sintered at a heating temperature of 400 °C or less, the collet A is preferably heated to a temperature of 200 °C or more. The collet A heated to 200 °C or more enables the sinterable particles to be more sufficiently sintered to each other. Accordingly, the semiconductor chip B can be more firmly bonded to the copper die pad E via the individual piece 2" of the sinter bonding layer. In other words, the semiconductor chip B is imparted an increased bonding reliability to the board.

When the above primary sintering treatment is carried out, it is preferable that the collet A be heated rapidly (i.e., within about 5 seconds). The collet A is preferably heated at a temperature rising rate of 30 °C/sec or more, more preferably heated at a temperature rising rate of 45 °C/sec or more.

The primary sintering treatment can be carried out not only by heating the collet A but also by heating the second stage H as well at the temperature as above. This enables the individual piece 2" of the sinter bonding layer to be heated from both sides in the thickness direction, and thus enables the sinterable particles to be more sufficiently sintered to each other. Accordingly, the semiconductor chip B can be more sufficiently bonded to the copper die pad E via the individual piece 2" of the sinter bonding layer. In other words, the semiconductor chip B is imparted a further increased bonding reliability to the board.

The heated second stage H preferably has such a temperature or less as to suppress the copper die pad E or the copper thin layer F from being oxidized. The heating temperature of the second stage H is preferably 150 °C or less.

When the primary sintering treatment is carried out as above, for example, the temperature of the collet A can be decreased to a temperature at which the sinterable particles are hardly sintered to each other (e.g., 50 °C) by lifting up the collet A after the primary sintering treatment to make a clearance between the semiconductor chip B and the collet A. When each of all individual pieces 2" of the sinter bonding layer is subjected to the primary sintering treatment, bonding wires can be bonded to required positions after all the semiconductor chips B are bonded.

In the method for producing the semiconductor device, a heating step of heating the individual piece 2" of the sinter bonding layer to a temperature at which the sinterable particles are sinterable to each other can be carried out after the plurality of semiconductor chips B are temporarily fixed to the board. In the heating step, heating can be carried out while compression force is applied in the thickness direction to at least any one of the plurality of individual pieces 2" of the sinter bonding layer. When the primary sintering treatment as described above is carried out, the heating step corresponds to a secondary sintering treatment. In other words, the sintering treatment can be carried out by both the primary sintering treatment and the secondary sintering treatment (i.e., the above heating step) as described above.

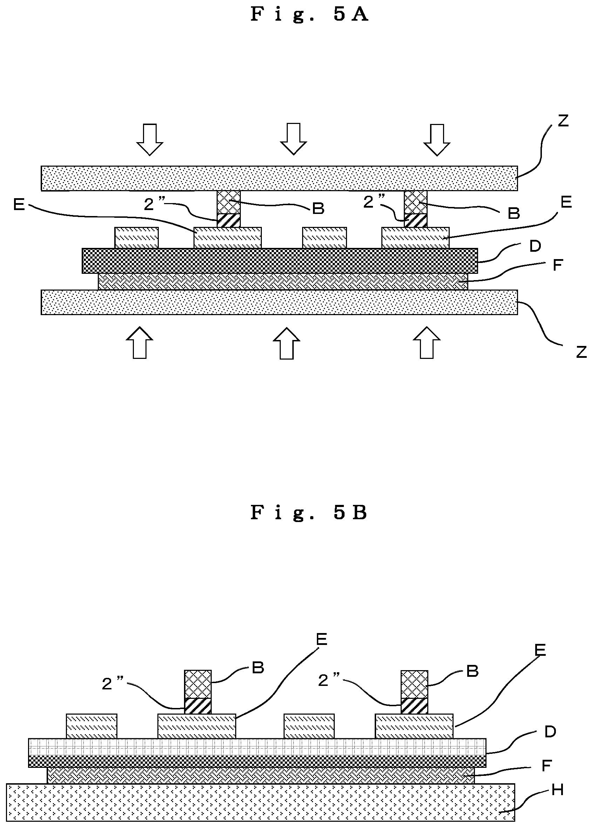

More specifically, in the method for producing the semiconductor device, the sintering treatment can be carried out as follows. In the heating step of the sintering treatment, for example, heating is carried out while at least any one of the plurality of the individual pieces 2" of the sinter bonding layer is pressed in its thickness direction. Specifically, after the semiconductor chips B are temporarily fixed, heating can be carried out using a heating and pressurizing device as shown in Fig. 5A configured to be capable of heating while compression force is applied in the thickness direction to the individual pieces 2" of the sinter bonding layer. The heating and pressurizing device includes, for example, two flat plates Z. The two flat plates Z are placed to allow the board (the ceramic insulating layer D, the copper die pad E, and the copper thin layer F) and the plurality of semiconductor chips B temporarily fixed to the copper die pad E via the respective individual pieces 2' of the sinter bonding layer to be sandwiched therebetween. Then, a distance between the two heated flat plates is made small to pressurize (press) the plurality of members above, thereby heating the individual pieces 2" of the sinter bonding layer while pressing these pieces. A buffer material (made of, e.g., PTFE having a thickness of 10 µm to 2 mm) configured to absorb pressing force to prevent the semiconductor chips B and the individual pieces 2" of the sinter bonding layer from tilting due to the pressing can be disposed between the plurality of semiconductor chips B and one of the two flat plates Z. The heating step thus carried out enables the plurality of individual pieces 2" of the sinter bonding layer to be heated while being pressed, thereby being capable of firmly bonding the semiconductor chips B to the board (copper die pad E) via the respective individual pieces 2" of the sinter bonding layer. Accordingly, the semiconductor chips B can be imparted an increased bonding reliability to the board. Following such a heating step, bonding wires can be bonded to required positions. A jig for arranging a plurality of the boards, for example, can be disposed between the copper die pad E and a lower one of the flat plates Z shown in Fig. 5A.

In the heating step, in contrast, after all those semiconductor chips B to be bonded are temporarily fixed, the second stage H can be heated without applying compression force in the thickness direction to the respective individual pieces 2" of the sinter bonding layer, as shown in Fig. 5B. In so doing, the second stage H is heated at a temperature at which the sinterable particles included in the individual pieces 2" of the sinter bonding layer are made sinterable (for example, any temperature within a range of 200 °C or more and 400 °C or less). Such a heating step still enables the semiconductor chips B to be firmly bonded to the board (copper die pad E) via the respective individual pieces 2" of the sinter bonding layer. Accordingly, the semiconductor chips B can be imparted an increased bonding reliability to the board. The heating step as above eliminates the necessity of the heating and pressurizing device for applying compression force to the individual pieces 2" of the sinter bonding layer, and can thus only require further simplified production equipment.

In the method for producing the semiconductor device, further steps can be carried out. For example, a wire bonding step of electrically connecting a part of each of the semiconductor chips B and a part of the board to each other can be carried out. Further, a sealing step of sealing, for example, the semiconductor chip B and the individual piece 2" of the sinter bonding layer using a thermosetting resin such as an epoxy resin can be carried out. In the sealing step, heating treatment is performed at a temperature of, for example, 150 °C or more and 200 °C or less to allow the curing reaction of the thermosetting resin to proceed.

In the method for producing the semiconductor device, the individual piece 2" of the sinter bonding layer is subjected to sintering treatment in which the individual piece 2" of the sinter bonding layer is heated while being applied with compression force in the thickness direction, thereby bonding the individual piece 2" of the sinter bonding layer to the board as described above.

The sinter bonding sheet of this embodiment and the method for producing thereof have been described as above, but the present invention is not limited to the above-described sinter bonding sheet and the method for producing thereof. That is, various forms used in, for example, general sinter bonding sheets can be employed without impairing the effect of the present invention.

The matters disclosed herein include the following.
(1) A sinter bonding sheet including: a sinter bonding layer including sinterable particles containing a conductive metal, and an organic binder; and
   a substrate layer layered on at least one surface of the sinter bonding layer, in which
   the at least one surface of the sinter bonding layer on which the substrate layer is layered has a surface roughness Ra of 10.5 nm or more and 90.0 nm or less.
(2) The sinter bonding sheet according to (1) above, in which the sinterable particles have an average particle size of 0.01 µm or more and 10 µm or less.
(3) The sinter bonding sheet according to (1) or (2) above, in which the sinter bonding layer includes 80 mass % or more and 99 mass % or less of the sinterable particles.
(4) The sinter bonding sheet according to any of (1) to (3) above, in which the sinter bonding layer has a thickness of 10 µm or more and 300 µm or less.
(5) The sinter bonding sheet according to any of (1) to (4) above, in which the substrate layer has a thickness of 10 µm or more and 200 µm or less.
(6) The sinter bonding sheet according to any of (1) to (5) above, being in a rolled state.
(7) The sinter bonding sheet according to (6) above, including a roll core having a circular cylindrical shape around which a layered product of the sinter bonding layer and the substrate layer is wound, in which the roll core has a diameter of 30 mm or more and 260 mm or less.
(8) A method for producing a sinter bonding sheet including: a sinter bonding layer including sinterable particles containing a conductive metal, and an organic binder; and a substrate layer layered on at least one surface of the sinter bonding layer, the method including:
   forming a plurality of intermediates of the sinter bonding layer each into a sheet shape by volatilizing a solvent from a varnish including the sinterable particles, the organic binder, and the solvent; and
   applying press treatment to the sinter bonding layer formed by attaching the plurality of intermediates to each other, in which
   in the press treatment, a pressure of 0.1 MPa or more and 10.0 MPa or less is applied at a temperature of 30 °C or more and 150 °C or less to the sinter bonding layer with the at least one surface thereof being in abutting contact with the substrate layer.

In the sinter bonding sheet and the method for producing the sinter bonding sheet, provided can be a sinter bonding sheet having good transfer properties of the sinter bonding layer to the semiconductor chip and configured to allow the substrate layer to be less likely separated and lifted from the sinter bonding layer.

### EXAMPLES

Next, the present invention will be described in more detail by way of experimental examples. The following examples are intended to illustrate the present invention in further detail, and are not intended to limit the scope of the present invention.

### (Materials of sinter bonding layer)

### [Sinterable particles]

- Silver particles (mixture of first silver particles and second silver particles below; mass ratio = 9/1)
   First silver particles (average particle size of 60 nm, manufactured by DOWA ELECTRONICS MATERIALS CO., LTD.)
   Second silver particles (average particle size of 1100 nm, manufactured by Mitsui Mining & Smelting Co., Ltd.)

### [Organic binders]

- First organic binder (thermally decomposable polymer binder): Polycarbonate resin: Product name: "QPAC 40" manufactured by Empower Materials
- Second organic binder (highly volatile binder): Isobornyl cyclohexanol Product name "Terusolve MTPH" manufactured by NIPPON TERPENE CHEMICALS, INC.

### (Substrate layer)

- Release treatment film (product name "DIAFOIL MRA 38" manufactured by Mitsubishi Chemical Corporation), 38 µm thick

### (Example 1)

The first silver particles, the second silver particles, the first organic binder (polycarbonate resin), and the second organic binder (isobornyl cyclohexanol) were dissolved or suspended in an organic solvent in the mixing proportions shown in Table 1 and Table 2 to prepare a varnish. Specifically, a hybrid mixer (model "HM-500" manufactured by Keyence Corporation) was used and the mixture was stirred in a stirring mode for three minutes. Next, the varnish was applied to a release treatment surface of the substrate layer, followed by being heated at 110 °C for three minutes to thereby form an intermediate of the sinter bonding layer in a sheet shape on the substrate layer. The layered sheet (layered sheet with the intermediate) was thus fabricated. Next, two layered sheets (two layered sheets each having the intermediate) being fed from the two respective roll bodies were layered on each other to have their sheet-like intermediates attached to each other, and then subjected to press treatment under the conditions shown in Table 3. Then, the layered sheets after the press treatment were wound with a winding force of 70 N or less to produce the sinter bonding sheet in a rolled state having a 50 µm thick sinter bonding layer. The roll core used for winding the sheet had a diameter of 203 mm. It should be noted that the mixing amount of the sinterable particles in Table 1 is represented by the amount at the time of preparation, while the mixing amount of the sinterable particles in Table 2 is represented by an ash content value.

**Table 1**

| | | Mixing proportion (mass %) |
|---|---|---|
| Sinterable particles | First silver particles | 90 |
| | Second silver particles | 10 |
| Organic binder | First organic binder | 20 |
| | Second organic binder | 80 |

**Table 2**

| Unit: Mass parts (total solid content of 100 mass parts) | |
|---|---|
| | Varnish composition |
| Sinterable particles | 93 |
| Organic binder | 7 |

**Table 3**

| | Ex. 1 | C. Ex. 1 | C. Ex. 2 | C. Ex. 3 | Ex. 2 | Ex. 3 |
|---|---|---|---|---|---|---|
| Sinter bonding layer thickness [µm] | 50 | 50 | 25 | 25 | 50 | 50 |
| Whether sheet-like intermediates are attached | Attached | Attached | Attached | Not attached | Attached | Attached |
| Pressure at press treatment [N/mm²] | 0.9 | 10.4 | 10.4 | - | 3.2 | 10.0 |
| Temperature at press treatment [°C] | 85 | 85 | 85 | - | 50 | 50 |
| Surface roughness Ra [nm] | 15.7 | 9.7 | 10.2 | 91.7 | 11.0 | 18.1 |
| Whether sheet is rolled | Rolled | Rolled | Rolled | Rolled | Rolled | Not rolled |

| Performance evaluation | | | | | | |
|---|---|---|---|---|---|---|
| Transfer properties | Excellent (○) | Bad (x) | Bad (x) | Bad (x) | Good (Δ) | Excellent (○) |
| Lifting of substrate layer | No (○) | No (○) | No (○) | Yes (x) | No (○) | No (○) |

### (Examples 2 and 3)

Each sinter bonding sheet was produced in the same manner as above, except that the configuration and physical properties were changed to the corresponding configuration and physical properties shown in Table 3. In Example 3, the two layered sheets having a flat sheet shape were layered on each other and then subjected to press treatment using the flat plate press machine. The produced sinter bonding sheet remained in a flat sheet shape without being formed into a rolled state.

### (Comparative Examples 1 to 3)

Each sinter bonding sheet was produced in the same manner as above, except that the configuration and physical properties were changed to the corresponding configuration and physical properties shown in Table 3. In Comparative Example 3, the two layered sheets were not layered on each other (the sheet-like intermediates were not attached to each other), and were not subjected to press treatment.

Table 3 shows the configurations and the physical properties of the sinter bonding layers of the respective sinter bonding sheets according to Examples and Comparative Examples.

### <Surface roughness Ra of sinter bonding sheet (sinter bonding layer)>

For the sinter bonding layer of each of the sinter bonding sheets produced as above, the surface roughness Ra was measured by the above method. A reference length (L) at the time of measurement was 2.5 µm. The surface on which the surface roughness Ra was measured was in contact with the substrate layer. In each of Examples and Comparative Examples, the sinter bonding layer had both surfaces in contact with the respective substrate layers; thus, the surface roughness was measured for the both surfaces of the sinter bonding layer. As a result, the both surfaces shared the same surface roughness Ra.

### <Evaluation of transfer properties of sinter bonding layer>

The sinter bonding sheet according to each of Examples was evaluated for the transfer properties of the sinter bonding layer to a Si chip. The evaluation test was carried out as follows:
(1) A cushioning material ("FF10N" manufactured by Yamauchi Corporation) was placed on the stage of the flip chip bonder "FC3000W" manufactured by Toray Engineering Co.,Ltd. One substrate layer (release liner / release treatment film) was removed from the sinter bonding sheet according to each of Examples, and the sinter bonding sheet was placed on the cushioning material to have the exposed sinter bonding layer directed on the upper side.
(2) A Si chip (square with a side of 5 mm, thickness: 200 µm) with its entire one surface plated with silver was prepared. The one surface of the Si chip was pressed at the sinter bonding layer on the substrate layer using a collet heated to 100 °C, and was subjected to a load of 1 MPa (25 N) for one second. Next, the Si chip was lifted up with the collet at a speed of 0.3 mm/sec to separate an individual piece of the sinter bonding layer from the substrate layer.
(3) The size of the separated (transferred) sinter bonding layer was observed using a microscope.
(4) The operation including the steps (1) to (3) above was carried out three times, and the transfer properties were evaluated according to the following criteria:
   Excellent (∘): In all of the three operations, the sinter bonding layer was successfully lifted up (transferred) into the same size as that of the Si chip and without wrinkles formed thereon.
   Good (△): In any of the three operations, the sinter bonding layer was transferred into the same size as that of the Si chip, but partially had wrinkles formed thereon.
   Bad (×): In any of the three operations, the sinter bonding layer had wrinkles at a plurality of portions, causing a practical problem.

A favorable result can be obtained for the transfer properties as long as the surface of the sinter bonding layer in contact with the substrate layer when the Si chip is lifted up as above has a specific surface roughness. In other words, it is not necessary that both surfaces of the sinter bonding layer have a specific surface roughness.

### <Lifting of substrate layer in rolled state (separation between substrate layer and sinter bonding layer)>

A sinter bonding sheet having a thickness of 126 µm and a width of 120 mm was prepared with the same composition as that of each of Examples or each of Comparative Examples. In the sinter bonding sheet, the sinter bonding layer had a thickness of 50 µm, and the substrate layers (PET films) disposed on both surface sides of the sinter bonding layer each had a thickness of 38 µm. Each sinter bonding sheet was wound twice (i.e., 1300 mm worth) around the roll core having a cylindrical shape (made of an ABS resin in an outer diameter of 8 inches) at room temperature (23 °C) to fabricate a roll body. After 24 hours from the fabrication of the roll body, the lifting of the substrate layer was evaluated according to the following criteria. It should be noted that the sinter bonding sheet in a rolled state causes the substrate layer to be easily lifted from the sinter bonding layer.

No (∘): When 300 mm worth of the layered product of the substrate layer and the sinter bonding layer was unwound from the roll body, a portion of the unwound layered product close to the roll core did not have the substrate layer separated (lifted) from the sinter bonding layer.

Yes (×): When 300 mm worth of the layered product of the substrate layer and the sinter bonding layer was unwound from the roll body, a portion of the unwound layered product close to the roll core had the substrate layer separated (lifted) from the sinter bonding layer.

The lifting can be suppressed as long as the surface of the sinter bonding layer in contact with the substrate layer has a specific surface roughness. In other words, it is not necessary that both surfaces of the sinter bonding layer have a specific surface roughness.

As is understood from the evaluation results, the sinter bonding layer of the sinter bonding sheet according to each of the Examples exhibited favorable transfer properties to the semiconductor chips, and successfully suppressed the lifting of the substrate layer. The sinter bonding layer of the sinter bonding sheet according to each of the Examples also had favorable thermal conductivity and electrical conductivity. The sinter bonding layer of the sinter bonding sheet according to each of the Comparative Examples, on the other hand, lacked favorable transfer properties to the semiconductor chips. In each of the Comparative Examples having a surface roughness too large, the lifting of the substrate layer failed to be suppressed.

### Industrial Applicability

The sinter bonding sheet of the present invention is suitably used as, for example, an auxiliary tool for producing a semiconductor device.

### REFERENCE SIGNS LIST

10: Sinter bonding sheet
1: Substrate layer
2: Sinter bonding layer
A: Collet
B: Semiconductor chip
C: Dicing tape
D: Ceramic insulating layer
E: Copper die pad
F: Copper thin layer
G: First stage
H: Second stage

## Claims

1. A sinter bonding sheet comprising: a sinter bonding layer comprising sinterable particles containing a conductive metal, and an organic binder; and
a substrate layer layered on at least one surface of the sinter bonding layer, wherein
the at least one surface of the sinter bonding layer on which the substrate layer is layered has a surface roughness Ra of 10.5 nm or more and 90.0 nm or less.

2. The sinter bonding sheet according to claim 1, wherein the sinterable particles have an average particle size of 0.01 µm or more and 10 µm or less.

3. The sinter bonding sheet according to claim 1 or 2, wherein the sinter bonding layer comprises 80 mass % or more and 99 mass % or less of the sinterable particles.

4. The sinter bonding sheet according to claim 1 or 2, wherein the sinter bonding layer has a thickness of 10 µm or more and 300 µm or less.

5. The sinter bonding sheet according to claim 1 or 2, wherein the substrate layer has a thickness of 10 µm or more and 200 µm or less.

6. The sinter bonding sheet according to claim 1 or 2, being in a rolled state.

7. The sinter bonding sheet according to claim 6, comprising a roll core having a circular cylindrical shape around which a layered product of the sinter bonding layer and the substrate layer is wound, wherein the roll core has a diameter of 30 mm or more and 260 mm or less.

8. A method for producing a sinter bonding sheet comprising: a sinter bonding layer comprising sinterable particles containing a conductive metal, and an organic binder; and a substrate layer layered on at least one surface of the sinter bonding layer, the method comprising:
forming a plurality of intermediates of the sinter bonding layer each into a sheet shape by volatilizing a solvent from a varnish comprising the sinterable particles, the organic binder, and the solvent; and
applying press treatment to the sinter bonding layer formed by attaching the plurality of intermediates to each other, wherein
in the press treatment, a pressure of 0.1 MPa or more and 10.0 MPa or less is applied at a temperature of 30 °C or more and 150 °C or less to the sinter bonding layer with the at least one surface thereof being in abutting contact with the substrate layer.
